# EUROPÄISCHE PATENTSCHRIFT

(11) **EP 0 914 484 B1**
(45) Veröffentlichungstag und Bekanntmachung des Hinweises auf die Patenterteilung: **30.08.2000**
(21) Anmeldenummer: 97923705.4
(22) Anmeldetag: 09.06.1997
(51) Int. Cl.: C22C 19/05, C30B 11/00, C30B 29/52

(54) **NICKEL-BASIS-SUPERLEGIERUNG**
NICKEL-BASE SUPERALLOY
SUPERALLIAGE A BASE DE NICKEL

(30) Priorität: 17.06.1996 DE 19624056
(43) Veröffentlichungstag der Anmeldung: 12.05.1999
(73) Patentinhaber: ABB RESEARCH LTD., 8050 Zürich (CH)
(72) Erfinder: KONTER, Maxim, CH-5313 Klingnau (CH); NEWNHAM, Michael, Malvern, Worcs.WR13 5DN (GB); TÖNNES, Christoph, CH-5313 Klingnau (CH)
(74) Vertreter: Pöpper, Evamaria, Dr.
(86) Internationale Anmeldenummer: CH9700229
(87) Internationale Veröffentlichungsnummer: WO9748828

(56) Entgegenhaltungen:
- EP-A- 0 155 827
- EP-A- 0 208 645
- EP-A- 0 240 451
- WO-A-93/24683
- GB-A- 2 235 697
- US-A- 5 100 484
- US-A- 5 470 371
- JOURNAL OF MATERIALS ENGINEERING AND PERFORMANCE, Bd. 2, Nr. 4, August 1993, MATERIALS PARK US, Seiten 481-487, XP000394071 K.HARRIS ETAL: "DEVELOPMENT OF TWO RHENIUM-CONTAINING SUPERALLOYS FOR SINGLE-CRYSTAL BLADE AND DIRECTIONALLY SOLIDIFIED VANE APPLICATIONS IN ADVANCED TURBINE ENGINES"

## Beschreibung

### Technisches Gebiet

Die Erfindung betrifft eine Nickel-Basis-Superlegierung, insbesondere zur Herstellung von Einkristall-Komponenten.

### Stand der Technik

Aus Nickel-Basis-Superlegierungen werden Einkristall-Komponenten oder gerichtet erstarrte Komponenten hergestellt, insbesondere Turbinenschaufeln von Gasturbinen. Mittels dieser Einkristall-Komponenten kann die Materialfestigkeit bei hohen Temperaturen maximiert werden. Dadurch kann die Einlasstemperatur von Gasturbinen erhöht werden, wodurch die Effizienz der Gasturbine steigt.

Einkristall-Legierungen enthalten dazu mischkristallverfestigende Elemente wie Re, W, Mo, Co, Cr, sowie γ'-Phasen bildende Elemente wie Al, Ta und Ti. Fehlerfreie Gussteile aus Einkristall-Superlegierungen zeichnen sich durch eine relativ hohe Kriechfestigkeit, Dauerfestigkeit und Oxidationsbeständigkeit aus. Andererseit ist eine fehlerfrei Herstellung von Einkristallkomponenten, insbesondere von Schaufeln von Gasturbinen, sehr schwierig, besonders wenn diese Komponenten gross sind und eine komplizierte Geometrie aufweisen. Die Bildung von Kleinwinkelkorngrenzen ist deshalb ein charakteristischer Defekt für grosse Einkristall-Komponenten.

Konventionelle Einkristall-Superlegierungen, wie sie beispielsweise aus US 4,459,160, US 4,643,782 und EP 076 360 bekannt sind, haben einen so klein wie möglich gewählten Gehalt an Kohlenstoff und Bor (C ≤ 150 ppm, B ≤ 30 ppm) und weitere korngrenzenverfestigende Elemente wie Zr, Ce, usw., werden vermieden, um ein grosses Wärmebehandlungsfenster der Einkristall-Superlegierungen zu erhalten. Die Kleinwinkelkorngrenzen in diesen Legierungen sind sehr schwach und deshalb nicht akzeptabel. Die transversalen mechanischen Eigenschaften von grossen Einkristall-Komponenten aus Legierungen mit einem niedrigen C- und B-Gehalt sind sehr schlecht, so dass es bereits beim Guss zum Bruch der Komponenten kommen kann. Die Kleinwinkelkorngrenzen spielen dabei die Rolle von Diffusionswegen für Oxidations- und Korrosionsprozesse.
Diese Legierungen wurden für Flugzeug-Turbinen entwickelt und sind deshalb auf kurz- und mittelzeit Eigenschaften optimiert, d.h. die Gebrauchsdauer wird auf bis zu 20000 Stunden ausgelegt. Die Legierungen werden auf eine maximale Zeitstandfestigkeit bei hohen Temperaturen und hohen Spannungen optimiert und sollten dazu ein positives Wärmebehandlungsfenster aufweisen, d.h die primäre γ'-Phase wird voll gelöst ohne örtliches Voraufschmelzen der Legierung.

Einkristall-Superlegierungen mit einem gegenüber den eingangs beschriebenen Legierungen erhöhten C-, B- und Hf-Gehalt, wie sie beispielsweise aus GB 2 234 521, EP 240 451 und EP 208 645 bekannt sind, zeigen deutlich erhöhte Brucheigenschaften in transversaler Richtung. Die Oxidations- und Korrosionsbeständigkeit der Kleinwinkelkorngrenzen bleibt jedoch gering. Zudem fallen die LCF-(Ermüdung bei niedriger Lastspielzahl)-Eigenschaften in longitudinaler Richtung gegenüber den vorher beschriebenen Legierungen um 10%, aufgrund des schädlichen Einflusses der gebildeten zeilenförmigen Karbide.

Die WO-A-93/24683 beschreibt eine Nickel-Basis-Superlegierung die wahlweise bis zu 0.1 Gew.-% C und bis zu 0.5 Gew.-% Hf und 5 bis 200 ppm Mg aber kein B enthält. Mg wird zur Verbesserung der Oxidationsbeständigkeit hinzugefügt.

### Darstellung der Erfindung

Der Erfindung liegt die Aufgabe zugrunde, bei einer Nickel-Basis-Superlegierung, insbesondere zur Herstellung von grossen Einkristall-Komponenten der eingangs genannten Art auch bei grossen Gussteilen die longitudinale und transversale Dauerfestigkeit zu erhöhen und gleichzeitig eine hohe Oxidations- und Korrosionsbeständigkeit zu erreichen.

Erfindungsgemäss wird dies durch die Merkmale des ersten Anspruches erreicht.

Kern der Erfindung ist es also, eine Nickel-Basis-Superlegierung, umfassend (gemessen in Gew.-%) 6.0-6.8% Cr, 8.0-10.0% Co, 0.5-0.7% Mo, 6.2-6.6% W, 2.7-3.2% Re, 5.4-5.8% Al, 0.6-1.2% Ti, 6.3-7.0% Ta, 0.15-0.3% Hf, 0.02-0.04% C, 40-100 ppm B, 15-50 ppm Mg, 0-400 ppm Y, Rest Nickel mit Verunreinigungen.

Die Vorteile der Erfindung sind unter anderem darin zu sehen, dass die zulegierten Mengen an Korngrenzen-Elemente wie C, B, Hf und Mg einen positiven Einfluss auf die Kleinwinkelkorngrenzen haben. Die gebildeten Karbide werden sehr viel feiner und sind inselförmig ausgebildet. Die Karbide sind zudem hauptsächlich an den Kleinwinkelkorngrenzen angeordnet, wodurch die longitudinalen und transversalen mechanischen Eigenschaften und die Dauerfestigkeit der Einkristall-Komponenten entscheidend verbessert wird.
Durch die Zugabe von Mg in Kombination mit B, C und Hf wird eine Diffusion entlang der Kleinwinkelkorngrenzen behindert und es ergibt sich eine hohe Oxidationsbeständigkeit der Kleinwinkelkorngrenzen.

Es ist besonders zweckmässig, wenn Hf = (8 - 12)*C, B = (0.18 - 0.25)*C, Mg = (0.08 - 0.2)*C, oder Hf : C : B : Mg = 100 : 10 : 2 : 1 (in Gew.-%). Dadurch werden die Eigenschaften der Legierung bezüglich longitudinalen und transversalen mechanischen Eigenschaften, der Dauerfestigkeit und der Oxidationsbeständigkeit der Kleinwinkelkorngrenzen vorteilhaft beeinflusst.

Weitere vorteilhafte Ausgestaltungen der Erfindung ergeben sich aus den Unteransprüchen.

### Weg zur Ausführung der Erfindung

Im Gegensatz zu den eingangs erwähnten Legierungen aus US 4,459,160, US 4,643,782 und EP 076 360 werden Komponenten für industrielle Gasturbinen, welche für eine Gebrauchsdauer von bis zu 75000 Stunden ausgelegt sind, nur teilweise lösungsgeglüht, so dass ein Teil der primären γ'-Phase verbleibt. Dies ist nötig um eine Rekristallisation der Einkristall-Struktur zu verhindern. Somit wird eine Wärmebehandlung angewendet, welche die primäre γ'-Phase zu etwa 90 bis 97% löst. Dies erlaubt die Verwendung von Korngrenzen-Elementen, welche üblicherweise aufgrund ihrer Tendenz die örtlichen Voraufschmelztemperatur zu senken und entsprechend in Einkristall-Superlegierungen vermieden werden. Diese Korngrenzen-Elemente wie C, B, Hf und Mg haben einen positiven Einfluss auf die Kleinwinkelkorngrenzen.
Im Gegensatz zu den eingangs erwähnten Legierungen aus GB 2 234 521, EP 240 451 und EP 208 645 werden jedoch nicht nur die transversalen, mechanischen Eigenschaften verbessert, sondern auch die Korrosions- und Oxidationsbeständigkeit der Kleinwinkelkomgrenzen und die Dauerwechselfestigkeits-Eigenschaften.

Die erfindungsgemässe Legierung, welche zum Giessen von gerichtet erstarrten, grossen Einkristall-Komponenten entwickelt wurde, umfassend (in Gew.-%):

| | |
|---|---|
| Cr | 6.0 - 6.8 |
| Co | 8.0 - 10.0 |
| Mo | 0.5 - 0.7 |
| W | 6.2 - 6.6 |
| Re | 2.7 - 3.2 |
| Al | 5.4 - 5.8 |
| Ti | 0.6 - 1.2 |
| Ta | 6.3 - 7.0 |
| Hf | 0.15 - 0.3 |
| C | 0.02 - 0.04 |
| B | 40 - 100 ppm |
| Mg | 15 - 50 ppm |
| Ni | Rest, sowie unvermeidbare Verunreinigungen, |
| wobei | Hf = (8 - 12)*C, vorzugsweise 10*C; |
| | B = (0.18 - 0.25)*C, vorzugsweise 0.2*C; |
| | Mg = (0.08 - 0.2)*C, vorzugsweise 0.1*C; |
| oder | Hf : C : B : Mg = 100 : 10 : 2 : 1 (in Gew.-%) |

In der Tabelle 1 sind aus dem erfindungsgemässen Bereich ausgewählte Legierungen L1 und L2 mehreren Vergleichslegierungen VL10 bis VL17 gegenübergestellt. Die chemische Zusammensetzung der Vergleichslegierungen liegt ausserhalb der erfindungsgemässen Zusammensetzung. Die Vergleichslegierungen VL16 und VL17 sind dabei kommerziell verwendete Legierungen "CMSX-4" und Renè N5", die den in der Tabelle 1 angegebenen Schriften US 4,643,782 und US 5,270,123 entnommen sind.

In der Tabelle 2 werden die LCF-Eigenschaften der erfindungsgemässen Legierungen L1 und L2 mit einigen ausgewählten Vergleichslegierungen verglichen. Die Tabelle 2 zeigt die Anzahl der Zyklen bis zum Versagen Nf in einem symmetrischen LCF-Zyklus R = -1 bei einer totalen Dehnung Δεₜₒₜ= 1.2%.

In der Tabelle 3 werden die zyklische Oxidationsbeständigkeit der erfindungsgemässen Legierungen L1 und L2 mit einigen ausgewählten Vergleichslegierungen verglichen.

Die Vergleichslegierung VL10, welche ein typisches Beispiel der aus GB 2 234 521, EP 240 451 und EP 208 645 bekannten Legierungen ist, weist einen erhöhten C-, B- und Hf-Gehalt auf. Durch die Bildung von Karbo-Boriden entlang der Kleinwinkelkorngrenzen weist die VL10 verbesserte transversale mechanische Eigenschaften auf. Metallographische Untersuchungen von grossen, aus der Vergleichslegierung VL10 hergestellten Turbinenschaufeln zeigen, dass die gebildeten Karbide eine zeilenförmige Morphologie aufweisen und beinahe homogen über das Volumen verteilt sind. Deshalb spielt nur der kleine C-Gehalt, welcher in den Karbo-Boriden in den Kleinwinkelkorngrenzen gebunden ist eine positive Rolle für das mechanische Verhalten. Der restliche C-Anteil bildet in der Legierung die Zeilen-Karbide, welche die Dauerfestigkeit in longitudinaler Richtung senken, wie dies aus Tabelle 2 hervorgeht.

Eine geringe Zulegierung von Mg, ungefähr 10 bis 20% des C-Gehaltes, in Kombination mit einer Verdoppelung des B-Gehaltes und mit Hf, ändert den Karbid-Bildungsprozess in der Einkristall-Superlegierungen drastisch. Die Karbide in den erfindungsgemässen Legierungen L1 und L2 sind sehr viel feiner und inselförmig, im Gegensatz zur Vergleichslegierung VL10, wo sie lamellenförmig sind. Die Verteilung der Karbide im Legierungsvolumen ist inhomogen an den Kleinwinkelkorngrenzen konzentriert. Durch das Mg, das stark an die Komgrenzen seigert, wird die Segregation der karbidbildenden Elemente Hf, Ta und Ti beeinflusst und das Mg tritt in Wechselwirkung mit diesen Elementen. Der grosse Atomradius von Mg verursacht eine starke Gitterverzerrung an den Kleinwinkelkorngrenzen, was die Segregation von C in die Kleinwinkelkorngrenzen erleichtert. Die daraus entstehende feine und dichte Karbo-Borid-Struktur entlang den Korngrenzen verbessert die transversalen Eigenschaften und gleichzeitig die Dauerfestigkeit der Einkristall-Komponenten. Dies im Gegensatz zur Vergleichslegierung VL10, wo die Dauerfestigkeit durch die lamellar ausgebildeten Karbide gesenkt wird.

Aus der Tabelle 2, Vergleichsbeispiel VL11 folgt, dass wenn der Mg-Gehalt 50 ppm übersteigt, die transversalen mechanischen Eigenschaften stark abnehmen. Dies ist auf die Bildung von grossen Karbiden und Ni-Mg-Verbindungen entlang der Korngrenzen zurückzuführen.

Wenn der Gehalt an B (entsprechend Vergleichslegierung VL12) oder Hf (entsprechend Vergleichslegierung VL13) ungenügend ist, werden schädliche, grobe Karbide ausgeschieden. Dies hat die schlechten LCF-Eigenschaften der VL12 und VL13 gemäss der Tabelle 2 zur Folge.

Wird der B- und Hf-Gehalt zu sehr erhöht, bilden sich Eutektika mit einem tiefen Schmelzpunkt, wie das bei der Vergleichslegierung VL14 der Fall ist. Dies hat ebenfalls schlechte LCF-Eigenschaften zur Folge.

Wird der C-Gehalt zu sehr erhöht (entsprechend Vergleichslegierung VL 15), zeigt sich keine Verbesserung der transversalen Festigkeit, jedoch eine Verschlechterung der longitudinalen Eigenschaften.

Die Gegenwart von Kleinwinkelkorngrenzen ist auch schädlich für die Oxidationsbeständigkeit von Einkristall-Komponenten. Die Kleinwinkelkorngrenze spielen die Rolle von Diffusionswegen für Oxidationsprodukten und die Oxidation entlang von Kleinwinkelkorngrenzen ist stärker im Vergleich mit einer fehlerfreien Einkristall-Superlegierungen. Aus Tabelle 3 folgt, dass durch die Zugabe von B, C und Hf entsprechend VL10 die Oxidationsbeständigkeit der Kleinwinkelkorngrenzen nur leicht erhöht wird.

Die zusätzliche Zugabe von Mg in Kombination mit B, C und Hf entsprechend Legierung L1 und L2 ergibt eine viel vorteilhaftere Oxidationsbeständigkeit der Kleinwinkelkorngrenzen. Dies könnte durch ein "Ergreifen" von Sauerstoff- und Schwefelatomen durch Mg und die Bildung von stabilen Mg-O-S-Verbindungen erklärt werden, welche eine Diffusion entlang der Kleinwinkelkorngrenzen behindern.

Als weiteres Element kann gegebenenfalls Yttrium zulegiert werden. Yttrium verbessert die Oxidations- und Korrosionsbeständigkeit in Gehalten bis zu 400 ppm, insbesondere in Gehalten von 10 bis 400 ppm. Durch höhere Y-Gehalte fällt die Duktilität ab. Y dotierte Legierungen benötigen jedoch eine spezielle Giess-Technik, um eine Reaktion zwischen Giessform und Metall zu verhindern.

Die erfindungsgemässen Legierungen eignen sich hervorragend, um mit einem Wärmebehandlungsverfahren behandelt zu werden, dass folgende Schritte umfasst: Glühen bei 850°C bis 1100°C, insbesondere bei 930°C bis 970°C während 1 bis 4 Stunden und bei 1030°C bis 1070°C während 2 bis 20 Stunden, erwärmen auf 1200°C, erwärmen auf eine Temperatur 1200°C<T≤1300°C mit einer Aufheizrate kleiner gleich 1°C/min, insbesondere mit einer Aufheizrate von etwa 0.5°C/min, einem mehrstufigen Homogenisierungs- und Lösungsprozess bei einer Temperatur 1300°C ≤ T ≤ 1315°C, insbesondere bei etwa 1300°C während etwa 2 Stunden und anschliessend bei etwa 1310°C während 6 bis 12 Stunden.

Die Vorteile der Wärmebehandlung sind unter anderem darin zu sehen, dass durch das Verfahren Versetzungsquellen geschlossen und damit die Erzeugung weiterer Versetzungen verhindert wird. Weiter wird eine Rekristallisation währen dem Aufheizprozess vermieden und die Annihilation des Versetzungs-Netzwerkes forciert. Durch den mehrstufigen Homogenisierungs- und Lösungsprozess entsteht eine sehr gute Homogenisierung der Werkstoffkörper. Das verbleibende Eutektikum von 1 bis 4 Vol.-% reicht aus um die Korngrenzen von Rekristallisationskörner zu pinnen.

Selbstverständlich ist die Erfindung nicht auf das gezeigte und beschriebene Ausführungsbeispiel beschränkt. Grosse Komponenten aus der erfindungsgemässen Legierung können auch in andere Maschinen eingebaut werden, wo bei hohen Temperaturen eine stabile Struktur und hohe mechanische Eigenschaften benötigt werden.

**Tabelle 1:**

| Chemische Zusammensetzungen der Legierungen, Rest jeweils Ni | | | | | | | | | | | | |
|---|---|---|---|---|---|---|---|---|---|---|---|---|
| Elementgehalt, Gew.-% | Cr | Co | Mo | W | Re | Al | Ti | Ta | Hf | C, ppm | B, ppm | Mg, ppm |
| Legierung | | | | | | | | | | | | |
| L1 | 6.3 | 9.5 | 0.6 | 6.6 | 3 | 5.7 | 0.8 | 6.7 | 0.25 | 250 | 50 | 25 |
| L2 | 6.3 | 9.5 | 0.6 | 6.6 | 3 | 5.7 | 0.8 | 6.7 | 0.3 | 300 | 60 | 40 |
| VL10 | 6.3 | 9.5 | 0.6 | 6.6 | 3 | 5.7 | 0.8 | 6.7 | 0.2 | 330 | 50 | - |
| VL11 | 6.3 | 9.5 | 0.6 | 6.6 | 3 | 5.7 | 0.8 | 6.7 | 0.25 | 250 | 50 | 60 |
| VL12 | 6.5 | 9.5 | 0.6 | 6.6 | 3 | 5.7 | 0.8 | 6.7 | 0.25 | 250 | 25 | 40 |
| VL13 | 6.5 | 9.5 | 0.6 | 6.5 | 3 | 5.6 | 0.9 | 6.7 | 0.1 | 250 | 40 | 40 |
| VL14 | 6.5 | 9.5 | 0.6 | 6.5 | 3 | 5.6 | 0.9 | 6.7 | 0.35 | 250 | 80 | 40 |
| VL15 | 6.3 | 9.5 | 0.6 | 6.6 | 3 | 5.7 | 0.8 | 6.7 | 0.3 | 500 | 60 | 40 |
| | | | | | | | | | | | | |
| VL16 (CMSX-4, US 4,643,782) | 6.4 | 9.7 | 0.6 | 6.4 | 2.9 | 5.65 | 1.0 | 6.5 | 0.1 | 30 | - | - |
| VL17 (RenéN5, US 5,270,123) | 7 | 7.5 | 1.5 | 5 | 3 | 6.2 | - | 6.5 | 0.15 | 500 | 40 | - |

**Tabelle 2:**

| LCF-Eigenschaften von Einkristall-Superlegierungen | | |
|---|---|---|
| Legierung | N_{f} bei 1000°C, 6%/min., R=-1, Δεₜₒₜ = 1.2%; Zyklen | |
| | longitudinal <001> | transversal <010>, Kleinwinkelkorngrenzen 7 - 8° |
| L1 | 1442 | 1261 |
| L2 | 1430 | 1338 |
| VL10 | 1160 | 1020 |
| VL11 | - | 575 |
| VL12 | - | 545 |
| VL13 | - | 877 |
| VL14 | - | 766 |
| VL15 | 1197 | 1108 |
| VL16 | 1494 | 387 |

**Tabelle 3:**

| Zyklischer Oxidationsbeständigkeit von Einkristall-Superlegierungen | |
|---|---|
| Legierung | Tiefe des geschädigten Gebietes in Legierungen mit Kleinwinkelkorngrenzen 7 - 8°, nach 1000 Zyklen RT/1000°C, 1 Zyklus/h; µm. |
| L1 | 150 (entlang Kleinwinkelkorngrenzen) |
| L2 | 130 (entlang Kleinwinkelkorngrenzen) |
| VL10 | 290 (entlang Kleinwinkelkorngrenzen) |
| VL16 | 380 (entlang Kleinwinkelkorngrenzen) |
| VL16 (kleine Komponente, ohne Kleinwinkelkorngrenzen) | 60 (keine Kleinwinkelkorngrenzen) |

## Patentansprüche

1. Nickel-Basis-Superlegierung, insbesondere zur Herstellung von Einkristall-Komponenten, umfassend (gemessen in Gew.-%):
6.0-6.8% Cr, 8.0-10.0% Co, 0.5-0.7% Mo, 6.2-6.6% W, 2.7-3.2% Re, 5.4-5.8% Al, 0.6-1.2% Ti, 6.3-7.0% Ta, 0.15-0.3% Hf, 0.02-0.04% C, 40-100 ppm B, 15-50 ppm Mg, 0-400 ppm Y, Rest Nickel mit Verunreinigungen.

2. Nickel-Basis-Superlegierung nach Anspruch 1,
gekennzeichnet durch eine Zusammensetzung bestehend aus (in Gew.-%): 6.2-6.4% Cr, 9.4-9.6% Co, 0.6% Mo, 6.5-6.7% W, 2.9-3.1% Re, 5.7% Al, 0.7-0.9% Ti, 6.6-6.8% Ta, 0.25-0.3% Hf, 0.02-0.03% C, 50-60 ppm B, 25-40 ppm Mg, Rest Nickel mit Verunreinigungen.

3. Nickel-Basis-Superlegierung nach Anspruch 1 oder 2,
dadurch gekennzeichnet, dass
Hf = (8 - 12)*C, B = (0.18 - 0.25)*C, Mg = (0.08 - 0.2)*C,
oder Hf : C : B : Mg = 100 : 10 : 2 : 1 (in Gew.-%).

4. Nickel-Basis-Superlegierung nach Anspruch 1, 2 oder 3,
dadurch gekennzeichnet, dass
Hf = 10*C und / oder B = 0.2*C und / oder Mg = 0.1*C.

5. Nickel-Basis-Superlegierung nach einem der Ansprüche 1 bis 4,
dadurch gekennzeichnet,
dass 10-400 ppm Y vorliegt.

6. Nickel-Basis-Superlegierungs-Einkristallkomponente, bestehend aus (gemessen in Gew.-%):
6.0-6.8% Cr, 8.0-10.0% Co, 0.5-0.7% Mo, 6.2-6.6% W, 2.7-3.2% Re, 5.4-5.8% Al, 0.6-1.2% Ti, 6.3-7.0% Ta, 0.15-0.3% Hf, 0.02-0.04% C, 40-100 ppm B, 15-50 ppm Mg, 0-400 ppm Y, Rest Nickel mit Verunreinigungen.

7. Nickel-Basis-Superlegierungs-Einkristallkomponente nach Anspruch 6,
gekennzeichnet durch eine Zusammensetzung bestehend aus (in Gew.-%): 6.2-6.4% Cr, 9.4-9.6% Co, 0.6% Mo, 6.5-6.7% W, 2.9-3.1% Re, 5.7% Al, 0.7-0.9% Ti, 6.6-6.8% Ta, 0.25-0.3% Hf, 0.02-0.03% C, 50-60 ppm B, 25-40 ppm Mg, Rest Nickel mit Verunreinigungen.

8. Nickel-Basis-Superlegierung-Einkristallkomponente nach Anspruch 6 oder 7,
dadurch gekennzeichnet, dass
Hf = (8 - 12)*C, B = (0.18 - 0.25)*C, Mg = (0.08 - 0.2)*C,
oder Hf : C : B : Mg = 100 : 10 : 2 : 1 (in Gew.-%).

9. Nickel-Basis-Superlegierung-Einkristallkomponente nach Anspruch 6, 7 oder 8,
dadurch gekennzeichnet, dass
Hf = 10*C und / oder B = 0.2*C und / oder Mg = 0.1*C.

10. Nickel-Basis-Superlegierungs-Einkristallkomponente nach einem der Ansprüche 6 bis 9, dadurch gekennzeichnet,
dass die Einkristallkomponente eine Schaufel einer Gasturbine ist.

## Claims

1. A nickel-base superalloy, in particular for the fabrication of monocrystalline components, comprising (measured in wt %): 6.0-6.8% of Cr, 8.0-10.0% of Co, 0.5-0.7% of Mo, 6.2-6.6% of W, 2.7-3.2% of Re, 5.4-5.8% of Al, 0.6-1.2% of Ti, 6.3-7.0% of Ta, 0.15-0.3% of Hf, 0.02-0.04% of C, 40-100 ppm of B, 15-50 ppm of Mg, 0-400 ppm of Y, the remainder being nickel with impurities.

2. The nickel-base superalloy as claimed in claim 1, comprising a composition of (in wt %): 6.2-6.4% of Cr, 9.4-9.6% of Co, 0.6% of Mo, 6.5-6.7% of W, 2.9-3.1% of Re, 5.7% of Al, 0.7-0.9% of Ti, 6.6-6.8% of Ta, 0.25-0.3% of Hf, 0.02-0.03% of C, 50-60 ppm of B, 25-40 ppm of Mg, the remainder being nickel with impurities.

3. The nickel-base superalloy as claimed in claim 1 or 2, wherein Hf = (8-12)*C, B = (0.18 - 0.25)*C, Mg = (0.08 - 0.2)*C,
or Hf:C:B:Mg = 100:10:2:1 (in wt%).

4. The nickel-base superalloy as claimed in claim 1, 2 or 3,
wherein Hf = 10*C and/or B = 0.2*C and/or Mg = 0.1*C.

5. The nickel-base superalloy as claimed in any one of claims 1 to 4, wherein 10-400 ppm of Y are present.

6. The nickel-base superalloy monocrystalline component comprising (measured in wt %): 6.0-6.8% of Cr, 8.0-10.0% of Co, 0.5-0.7% of Mo, 6.2-6.6% of W, 2.7-3.2% of Re, 5.4-5.8% of Al, 0.6-1.2% of Ti, 6.3-7.0% of Ta, 0.15-0.3% of Hf, 0.02-0.04% of C, 40-100 ppm of B, 15-50 ppm of Mg, 0-400 ppm of Y, the remainder being nickel with impurities.

7. The nickel-base superalloy monocrystalline component as claimed in claim 6, wherein the composition comprises (in wt %): 6.2-6-4% of Cr, 9.4-9.6% of Co, 0.6% of Mo, 6.5-6.7% of W, 2.9-3.1% of Re, 5.7% of Al, 0.7-0.9% of Ti, 6.6-6.8% of Ta, 0.25-0.3% of Hf, 0.02-0.03% of C, 50-60 ppm of B, 25-40 ppm of Mg, the remainder being nickel with impurities.

8. The nickel-base superalloy monocrystalline component as claimed in claim 6 or 7, wherein Hf = (8-12)*C, B = (0.18 - 0.25)*C, Mg = (0.08 - 0.2)*C, or Hf:C:B:Mg = 100:10:2:1 (in wt%).

9. The nickel-base superalloy monocrystalline component as claimed in claim 6, 7 or 8,
wherein Hf = 10*C and/or B = 0.2*C and/or Mg = 0.1*C.

10. The nickel-base superalloy monocrystalline component as claimed in any one of claims 6 to 9, wherein the monocrystalline component is a blade of a gas turbine.

## Revendications

1. Superalliage à base de nickel, en particulier pour la préparation de composants monocristallins, comprenant (mesurés en % en poids) :
6,0-6,8% de Cr, 8,0-10,0% de Co, 0,5-0,7% de Mo, 6,2-6,6% de W, 2,7-3,2% de Re, 5,4-5,8% d'Al, 0,6-1,2% de Ti, 6,3-7,0% de Ta, 0,15-0,3% de Hf, 0,02-0,04% de C, 40-100 ppm de B, 15-50 ppm de Mg, 0-400 ppm de Y, le reste étant du nickel avec des impuretés.

2. Superalliage à base de nickel suivant la revendication 1, caractérisé par une composition constituée de (en % en poids) :
6,2-6,4% de Cr, 9,4-9,6% de Co, 0,6% de Mo, 6,5-6,7% de W, 2,9-3,1% de Re, 5,7% d'Al, 0,7-0,9% de Ti, 6,6-6,8% de Ta, 0,25-0,3% de Hf, 0,02-0,03% de C, 50-60 ppm de B, 25-40 ppm de Mg, le reste étant du nickel avec des impuretés.

3. Superalliage à base de nickel suivant la revendication 1 ou 2, caractérisé en ce que
Hf=(8-12)*C, B=(0,18-0,25)*C, Mg=(0,08-0,2)*C ou Hf:C:B:Mg=100:10:2:1 (en % en poids).

4. Superalliage à base de nickel suivant la revendication 1, 2 ou 3, caractérisé en ce que
Hf=10*C et/ou B=0,2*C et/ou Mg=0,1*C.

5. Superalliage à base de nickel suivant l'une des revendications 1 à 4, caractérisé en ce que 10-400 ppm d'Y sont présents.

6. Composant monocristallin de superalliage à base de nickel, constitué de (mesurés en % en poids):
6,0-6,8% de Cr, 8,0-10,0% de Co, 0,5-0,7% de Mo, 6,2-6,6% de W, 2,7-3,2% de Re, 5,4-5,8% d'Al, 0,6-1,2% de Ti, 6,3-7,0% de Ta, 0,15-0,3% de Hf, 0,02-0,04% de C, 40-100 ppm de B, 15-50 ppm de Mg, 0-400 ppm de Y, le reste étant du nickel avec des impuretés.

7. Composant monocristallin de superalliage à base de nickel suivant la revendication 6, caractérisé par une composition constituée de (en % en poids):
6,2-6,4% de Cr, 9,4-9,6% de Co, 0,6% de Mo, 6,5-6,7% de W, 2,9-3,1% de Re, 5,7% d'Al, 0,7-0,9% de Ti, 6,6-6,8% de Ta, 0,25-0,3% de Hf, 0,02-0,03% de C, 50-60 ppm de B, 25-40 ppm de Mg, le reste étant du nickel avec des impuretés.

8. Composant monocristallin de superalliage à base de nickel suivant la revendication 6 ou 7, caractérisé en ce que
Hf=(8-12)*C, B=(0,18-0,25)*C, Mg=(0,08-0,2)*C, ou Hf:C:B:Mg=100:10:2:1 (en % en poids).

9. Composant monocristallin de superalliage à base de nickel suivant la revendication 6, 7 ou 8, caractérisé en ce que
Hf=10*C et/ou B=0,2*C et/ou Mg=0,1*C.

10. Composant monocristallin de superalliage à base de nickel suivant l'une des revendications 6 à 9, caractérisé en ce que le composant monocristallin est une pale d'une turbine à gaz.
